(19) **Europäisches Patentamt**
**European Patent Office**
**Office européen des brevets**

(11) **EP 2 331 362 B1**

(12) **EUROPÄISCHE PATENTSCHRIFT**

(45) Veröffentlichungstag und Bekanntmachung des Hinweises auf die Patenterteilung:
**03.07.2013 Patentblatt 2013/27**

(51) Int Cl.:
*H03K 17/94* (2006.01)  *G06F 3/042* (2006.01)
*B60K 35/00* (2006.01)  *B60K 37/06* (2006.01)

(21) Anmeldenummer: **09778594.3**

(86) Internationale Anmeldenummer:
**PCT/EP2009/006740**

(22) Anmeldetag: **09.09.2009**

(87) Internationale Veröffentlichungsnummer:
**WO 2010/031565 (25.03.2010 Gazette 2010/12)**

(54) **BEDIENVORRICHTUNG UND VERFAHREN ZUM BETREIBEN EINER BEDIENVORRICHTUNG MIT VERBESSERTER ANNÄHERUNGSERFASSUNG**

OPERATOR CONTROL APPARATUS AND METHOD FOR OPERATING AN OPERATOR CONTROL APPARATUS WITH IMPROVED APPROACH SENSING

DISPOSITIF DE COMMANDE ET PROCÉDÉ POUR FAIRE FONCTIONNER UN DISPOSITIF DE COMMANDE À DÉTECTION D'APPROCHE AMÉLIORÉE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **22.09.2008 DE 102008048821**

(43) Veröffentlichungstag der Anmeldung:
**15.06.2011 Patentblatt 2011/24**

(73) Patentinhaber: **Volkswagen Aktiengesellschaft 38440 Wolfsburg (DE)**

(72) Erfinder:
• **WÄLLER, Christoph**
**38106 Braunschweig (DE)**

• **BACHFISCHER, Katharina**
**40476 Düsseldorf (DE)**
• **BENDEWALD, Lennart**
**38442 Wolfsburg (DE)**

(74) Vertreter: **Obst, Bernhard**
**Bressel und Partner**
**Patentanwälte**
**Park Kolonnaden**
**Potsdamer Platz 10**
**10785 Berlin (DE)**

(56) Entgegenhaltungen:
**EP-A1- 1 932 725    DE-A1-102004 033 275**
**JP-A- 2000 329 577    US-A1- 2004 140 959**
**US-A1- 2008 053 233**

**Beschreibung**

Die Erfindung betrifft eine Bedienvorrichtung gemäß dem Oberbegriff des Patentanspruchs 1 sowie ein Bedienverfahren mit den Merkmalen des Oberbegriffs des Patentanspruchs 12.

Heutzutage werden, insbesondere in modernen Kraftfahrzeugen, vermehrt Bedienvorrichtungen eingesetzt, die mindestens ein Bedienelement umfassen, welches in Abhängigkeit von einer Annäherung eines Betätigungselements, beispielsweise eines Körperteils eines Nutzers, vor einer Betätigung des Bedienelements automatisch verändert werden. Eine solche Veränderung kann beispielsweise eine Anpassung einer Hinterleuchtung sein. Zunehmend werden auch Anzeigevorrichtungen, die mit einem positionsbestimmenden Messsensor ausgestattet sind, der eine Position einer Berührung einer Anzeigefläche durch das Betätigungselement des Nutzers bestimmen kann, eingesetzt. Solche Anzeigevorrichtungen werden als Touchscreens bezeichnet. Auf der Anzeigevorrichtung werden beispielsweise Bedienelemente, welche auch als virtuelle Bedienelemente bezeichnet werden, eingeblendet, denen Funktionen und/oder Aktionen zugeordnet sind, die bei einer Berührung einer solchen als Touchscreen ausgebildeten Anzeigevorrichtung im Darstellungsbereich des entsprechenden virtuellen Bedienelements ausgeführt werden. Da die Anzeigefläche des Touchscreens auch zum Ausgeben von Informationen verwendet wird, ist es wünschenswert, möglichst viel der Anzeigefläche für eine Informationsvermittlung zur Verfügung zu haben, wenn keine Betätigungshandlung seitens des Nutzers vorgenommen wird. Eine Einblendung der virtuellen Bedienelemente oder zumindest eine Darstellung in einer Größe, die eine weitgehend fehlerfreie Berührung in deren Darstellungsbereich auch während einer Fahrt auf einem unebenen Fahrbahnbelag ermöglicht, erfolgt somit vorzugsweise nur, wenn eine Betätigungsabsicht seitens des Nutzers erkannt ist.

Aus dem Stand der Technik sind Bedienvorrichtungen bekannt, bei denen eine Betätigungsabsicht über ein Erkennen einer Annäherung des Betätigungselements des Nutzers an das entsprechende Bedienelement erkannt wird. Eine solche interaktive Bedienvorrichtung und ein Verfahren zum Betreiben einer solchen interaktiven Bedienvorrichtung sind beispielsweise in der DE 10 2006 037 156 beschrieben. Dort ist beschrieben, eine Position des Betätigungselements relativ zu einer Anzeigefläche eines Touchscreens dreidimensional im Raum zu bestimmen. Hierfür werden mehrere benachbart zu dem Touchscreen angeordnete Entfernungsmesssensoren verwendet und über eine Triangulation die Position des Betätigungselements bestimmt. Die Entfernungsmesssensoren können nach unterschiedlichen Prinzipien betrieben werden.

Bei einem beschriebenen Messprinzip werden über den Körper des Nutzers übertragene Hochfrequenzsignale verwendet. Nahe dem Körper des Nutzers ist ein Hochfrequenzsender angeordnet. In einem Kraftfahrzeug befindet sich ein solcher Hochfrequenzsender vorzugsweise integriert in einem Fahrzeugsitz. Die in den Körper des Nutzers eingekoppelten Hochfrequenzsignale werden von den Entfernungsmesssensoren kapazitiv empfangen. Anhand einer Signalstärke kann die Entfernung eines Körperteils von dem Entfernungsmesssensor ermittelt werden. Anhand mehrerer solcher Entfernungsmesssensoren, die in einer Sensoranordnung angeordnet sind, kann eine Positionsbestimmung des Körperteils im Raum mittels Triangulation vorgenommen werden. Das Grundprinzip ist detaillierter beispielsweise in der Druckschrift WO 2004/07 85 36 beschrieben.

Auch aus der DE 10 2004 033 275 A1 sind eine Freigabevorrichtung und ein Verfahren zum Freigeben oder Sperren einzelner vorbestimmter Funktionen eines Geräts in einem Kraftfahrzeug während der Fahrt des Kraftfahrzeugs, insbesondere für den Fahrer und/oder den Beifahrer, bekannt, die das soeben genannte Grundprinzip für eine Fahrer- und/oder Beifahrererkennung oder -unterscheidung nutzen. Insbesondere können einzelne Funktionen, welche beispielsweise auf einer Anzeigeeinrichtung dargestellt werden, freigegeben oder gesperrt werden. Als alternative Überwachungseinrichtung zur Nutzererkennung ist auch eine Lichtschrankeneinrichtung erwähnt.

Aus der EP 1 932 725 A1 ist eine Datenverarbeitungsvorrichtung mit einer Annäherungserkennung bekannt.

Auch aus der US 2004/0140959 A1 ist eine Anzeigevorrichtung mit einem Bedienelements bekannt, welches mit einer Annäherungserkennung gekoppelt ist.

Aus der US 2008/0053233 ist eine Navigationsvorrichtung bekannt, bei der mittels Ultraschallsensoren eine Annäherung erkannt werden kann.

Ferner ist aus der JP 2000329577 A ein Navigationssystem mit einer Fahrer-Beifahrer-Unterscheidung bekannt.

In der DE 10 2006 037 156 ist alternativ ein Messprinzip beschrieben, welches mit optischen Sensoreinheiten ausgestaltet ist. Eine optische Sensoreinheit zur Bestimmung einer Entfernung kann beispielsweise gemäß folgendem Prinzip ausgestaltet sein. Eine Sende-LED strahlt ein rechteckförmig amplitudenmoduliertes Lichtsignal im optischen oder infraroten Wellenlängenbereich ab. Das an dem Objekt reflektierte Lichtsignal wird von einer Fotodiode erfasst. Von einer Kompensations-LED wird ein um 180° phasenversetztes ebenfalls rechteckförmig amplitudenmoduliertes Referenzlichtsignal zu der Photodiode über einen unveränderlichen Lichtweg gesandt. Die Kompensations-LED wird über einen Regelkreis mittels eines Regelsignals so ausgeregelt, dass sich das empfangene reflektierte Lichtsignal der Sende-LED und das empfangene Referenzlichtsignal der Kompensations-LED an der Photodiode aufheben und ein Gleichtaktsignal detektiert wird. Eine Änderung des Regelsignals ist ein Maß für einen Abstand des Betätigungselements bzw. Objekts. Eine nach diesem Prinzip ausgestaltete Sensoreinheit ist weitgehend unabhängig von Temperatur- und Helligkeitsschwankungen.

Den bekannten Vorrichtungen ist gemeinsam, dass diese eine Vielzahl von Entfernungsmesssensoren benötigen, um eine Annäherung an den Touchscreen zuverlässig erkennen zu können. Dies gilt insbesondere dann, wenn eine Annäherung an den Touchscreen von einer Annäherung an benachbart angeordnete Bedienelemente unterschieden werden soll. Darüber hinaus ist in der Regel eine Kalibration der Entfernungsmesssensoren notwendig, da beispielsweise eine kapazitive Kopplung von Umwelteinflüssen, beispielsweise einer Luftfeuchtigkeit und/oder einer individuellen Leitfähigkeit der Haut des Nutzers oder im Falle eines nach einem optischen Prinzip wirkenden Messsensors von einer Reflektivität des Betätigungselements abhängig ist.

Der Erfindung liegt somit die technische Aufgabe zugrunde, eine Bedienvorrichtung mit einer Annäherungserkennung zu schaffen, die zuverlässig und robust eine Annäherung eines Betätigungselements an mindestens ein Bedienelement erkennt und die bekannten Nachteile aus dem Stand der Technik nicht aufweist.

Die technische Aufgabe wird erfindungsgemäß durch eine Bedienvorrichtung mit den Merkmalen des Patentanspruchs 1 sowie ein Verfahren zum Betreiben einer solchen Bedienvorrichtung mit den Merkmalen des Patentanspruchs 12 gelöst. Vorteilhafte Ausgestaltungen der Erfindung ergeben sich aus den Unteransprüchen.

Insbesondere wird eine Bedienvorrichtung vorgeschlagen, welche mindestens ein Bedienelement zum Erfassen von Nutzereingaben und eine Annäherungserkennungseinrichtung umfasst, die ausgebildet ist, eine Annäherung eines Betätigungselements, insbesondere eines Körperteils, eines Nutzers an das mindestens eine Bedienelement vor einer Berührung des mindestens einen Bedienelements zu erfassen, wobei die Annäherungserkennungseinrichtung eine Reflexionslichtschranke umfasst, die mindestens ein Leuchtmittel zum emittieren von elektromagnetischer Detektionsstrahlung vor das Bedienelement in einen räumlich begrenzten Detektionsbereich, der nicht das gesamte Volumen vor dem mindestens einen Bedienelement umfasst, und ein Empfangselement zum Detektieren eines an dem Betätigungselement des Nutzers bei einer Annäherung an das mindestens eine Bedienelement gestreuten oder reflektierten Anteils der Detektionsstrahlung aufweist, wobei die Annäherungserkennungseinrichtung ausgebildet ist, eine Annäherung anhand einer Intensität der empfangenen Detektionsstrahlung zu erkennen. Während bei den im Stand der Technik bekannten Einrichtungen, die zur Informationsvermittlung über den Abstand des Betätigungselements von dem mindestens einen Bedienelement verwendete elektromagnetische Strahlung in einen großen Raumwinkelbereich abgestrahlt wird, der im Wesentlichen den gesamten Raum vor dem mindestens einen Bedienelement umfasst, um eine Annäherung zuverlässig erfassen zu können, ist es erfindungsgemäß vorgesehen, die Detektionsstrahlung nur in einen lokal begrenzten Detektionsbereich auszusenden. Dieser ist relativ zu dem mindestens einen Bedienelement so angeordnet und ausgestaltet, dass das Betätigungselement in diesen Detektionsbereich eindringt und/oder diesen durchdringt, bevor eine und/oder während eine betätigende Berührung des mindestens einen Bedienelements durch das Betätigungselement stattfindet. Für eine Erkennung einer Annäherung ist es daher ausreichend, einen Anteil der reflektierten und/oder gestreuten Detektionsstrahlung zu empfangen, der oberhalb eines Schwellenwertes liegt. Der Schwellenwert wird abhängig von dem Spektralbereich der Detektionsstrahlung gewählt. Abhängig davon, ob in diesem Spektralbereich Hintergrundstrahlung am Einsatzort, beispielsweise im Kraftfahrzeug, existiert oder nicht, ist der Schwellenwert festzulegen. Wird beispielsweise Detektionsstrahlung im optischen oder infraroten Wellenlängenbereich verwendet, so ist beispielsweise bei einem Einsatz im Fahrzeug durch die Fahrzeugscheiben eintretendes sichtbares und/oder infrarotes Licht entsprechend zu berücksichtigen. Ein erfindungsgemäßes Verfahren zum Betreiben einer Bedienvorrichtung, wobei die Bedienvorrichtung mindestens ein Bedienelement zum Erfassen von Nutzereingaben und eine Annäherungserkennungseinrichtung umfasst, die eine Annäherung eines Betätigungselements, insbesondere eines Körperteils, eines Nutzers an das mindestens eine Bedienelement vor einer Berührung des mindestens einen Bedienelements erfasst, ist so ausgestaltet, dass mittels mindestens eines Leuchtmittels elektromagnetische Detektionsstrahlung in einen räumlich begrenzten Detektionsbereich vor das mindestens eine Bedienelement emittiert wird, wobei der Detektionsbereich nicht ein gesamtes Volumen vor dem mindestens einen Bedienelement umfasst, und mittels eines Empfangselements bei einer Annäherung des Betätigungselements des Nutzers an das mindestens eine Bedienelement ein an dem Betätigungselement gestreuter und/oder von diesem Betätigungselement reflektierter Anteil der Detektionsstrahlung empfangen wird und anhand einer Intensität des empfangenen Anteils der Detektionsstrahlung die Annäherung erkannt wird.

Um zu erreichen, dass das von den Leuchtmitteln ausgesandte Licht, d.h. die elektromagnetische Detektionsstrahlung nur in einen räumlich begrenzten Detektionsbereich, welcher fächerförmig ausgebildet ist, emittiert wird, ist mit dem mindestens einen Leuchtmittel erfindungsgemäß eine Optik gekoppelt, die die Emission der Detektionsstrahlung in einen fächerförmigen Raumbereich lenkt.

Besonders vorteilhaft ist die Bedienvorrichtung als Bedienvorrichtung in einem Fahrzeug, besonders bevorzugt in einem Kraftfahrzeug ausgebildet. Das Verfahren ist entsprechend als Verfahren zum Betreiben einer Bedienvorrichtung in einem Fahrzeug, besonders bevorzugt in einem Kraftfahrzeug, ausgestaltet.

Besonders vorteilhaft ist vorgesehen, dass das mindestens eine Bedienelement ein Touchscreen ist und bei einer erkannten Annäherung eine Anpassung der Darstellung auf dem Touchscreen vorgenommen wird. Hierfür ist der Touchscreen vorzugsweise mit einer Steuereinrichtung verknüpft oder umfasst eine solche, die die grafische Darstellung auf der Anzeigefläche des Touchscreens steuert.

Zusätzlich zu einem Touchscreen umfasst eine Bedieneinrichtung häufig zusätzliche Bedienelemente, die beispielsweise als Tastschalter, Drehdrückschalter, Schieberegler usw. ausgebildet sein können. Um eine Annäherung des Betätigungselements an ein solches zusätzliches Bedienelement von einer Annäherung an das mindestens eine Bedienelement. welches vorzugsweise als Touchscreen ausgebildet ist, unterscheiden zu können, ist bei einer bevorzugten Ausführungsform der Erfindung vorgesehen, dass zum Erfassen der Nutzereingaben mindestens ein zusätzliches Bedienelement vorgesehen ist, das benachbart zu einem Rand der Anzeigefläche des Touchscreens angeordnet ist, wobei die Detektionsstrahlung des mindestens einen Leuchtmittels zwischen dem Rand des Touchscreens und dem mindestens einen zusätzlichen Bedienelement in den Detektionsbereich emittiert wird, der in einer Detektionsebene liegt, wobei die Detektionsebene und eine Ebene der Anzeigefläche des Touchscreens einen Winkel kleiner 90° einschließen, so dass eine Betätigung des mindestens einen zusätzlichen Bedienelements möglich ist, ohne mit dem Betätigungselement in den Detektionsbereich einzudringen. Je nach Einbaulage des mindestens einen Bedienelements und des mindestens einen zusätzlichen Bedienelements, beispielsweise im Bereich eines Kraftfahrzeugcockpits, ist es somit möglich, dass der Nutzer entlang mindestens eines Randes des als Touchscreen ausgebildeten mindestens einen Bedienelements ein angeordnetes zusätzliches Bedienelement berührend betätigen kann, ohne in den Detektionsbereich einzudringen, in den die Detektionsstrahlung vor das mindestens eine Bedienelement emittiert wird. In der Regel wird das mindestens eine Bedienelement, welches als Touchscreen ausgebildet ist, in einer Mittelkonsole so angeordnet sein, dass das Betätigungselement bei einer berührenden Betätigung des mindestens einen Bedienelements, d.h. des Touchscreens, jeweils einen unteren Rand der Anzeigefläche des Touchscreens überlagert bzw. überdeckt. ist die Reflexionslichtschranke folglich so ausgebildet, dass die Detektionsstrahlung von unterhalb des Touchscreens schräg zu einer Oberflächennormale der Anzeigefläche des Touchscreens in einen räumlich begrenzten Detektionsbereich emittiert wird, welcher ebenenförmig ausgebildet ist, so durchdringt das Betätigungselement diesen Detektionsbereich bei einer berührenden Betätigung. Wird hingegen ein zusätzliches Bedienelement, welches benachbart zu dem unteren Rand des Touchscreens angeordnet ist, betätigt, so ist eine berührende Betätigung möglich, ohne dass beispielsweise die Fingerknöchel in den Detektionsbereich eindringen, während das zusätzliches Bedienelement berührend betätigt wird.

Da es häufig schwierig ist, den Detektionsbereich vor dem mindestens einen Bedienelement vollständig und gleichmäßig mit Detektionsstrahlung auszufüllen, die von einem einzigen Leuchtmittel emittiert wird, ist bei einer Weiterbildung der Erfindung vorgesehen, dass die Annäherungserkennungseinrichtung ein oder mehrere zusätzliche Leuchtmittel umfasst, die ausgebildet sind, Detektionsstrahlung in den Detektionsbereich zu emittieren, wobei das mindestens eine Leuchtmittel und das oder die zusätzlichen Leuchtmittel jeweils ihre Detektionsstrahlung in unterschiedliche Raumbereiche des Detektionsbereichs emittieren. Diese unterschiedlichen Raumbereiche können sich bei einigen Ausführungsformen zumindest teilweise überlappen. Bei anderen Ausführungsformen sind die unterschiedlichen Raumbereiche so ausgestaltet, dass diese weitestgehend oder vollständig disjunkt sind.

Während zu dem einen Rand des Touchscreens benachbart angeordnete Bedienelemente bei geeigneter Emission der Detektionsstrahlung zwischen dem einen Rand und dem einen weiteren Bedienelement möglich ist, ist eine berührende Betätigung von benachbart zu anderen Rändern des als Touchscreen ausgebildeten oder angeordneten weiteren Bedienelementen häufig nicht möglich, ohne dass das Betätigungselement in den Detektionsbereich vor dem mindestens einen Bedienelement eindringt. Um jedoch eine grafische Anpassung der Darstellung in solchen Situationen zu verhindern, in denen lediglich ein benachbart zu dem mindestens einen Bedienelement angeordnetes weiteres Bedienelement betätigt werden soll, ist es vorteilhaft, eine Annäherung an dieses mindestens eine weitere Bedienelement gesondert von einer Annäherung an das mindestens eine Bedienelement unterscheiden zu können.

Eine bevorzugte Ausführungsform der Erfindung sieht hierfür vor, dass die Annäherungserkennungseinrichtung mindestens ein weiteres Leuchtmittel zum Emittieren von elektromagnetischer Detektionsstrahlung in einen von dem Detektionsbereich verschiedenen weiteren Detektionsbereich, mindestens eine Modulationsvorrichtung zum Modulieren der emittierten Detektionsstrahlung mindestens eines der Leuchtmittel, so dass sich zumindest die in den mindestens einen weiteren Detektionsbereich emittierte weitere Detektionsstrahlung von der in den Detektionsbereich emittierten Detektionsstrahlung hinsichtlich ihrer Modulation unterscheidet, und eine Analyseeinheit umfasst, die ausgebildet ist, die empfangene reflektierte und/oder gestreute Detektionsstrahlung hinsichtlich ihrer Modulation zu analysieren, um zumindest einen gestreuten/reflektierten Anteil der in den weiteren Detektionsbereich emittierten Detektionsstrahlung getrennt von dem gestreuten/reflektierten Anteil der in den Detektionsbereich emittierten Detektionsstrahlung zu ermitteln, und ein Eindringen des Betätigungselements in den mindestens einen weiteren Detektionsbereich anhand der Intensität des Anteils an empfangener reflektierter/gestreuter in diesen mindestens einen weiteren Detektionsbereich emittierter Detektionsstrahlung zu erkennen.

Vorteilhafterweise ist die Steuereinrichtung dann so ausgebildet, die Veränderung der Darstellung zu unterlassen, wenn zusätzlich zu der Annäherung an das mindestens eine Bedienelement ein Eindringen des Betätigungselements in den mindestens einen weiteren Detektionsbereich erkannt ist. Eine Ausführungsform sieht vor, dass die Anpassung der Darstellung unterbleibt, wenn zusätzlich zu der Annäherung an das mindestens eine Bedienelement ein Eindringen des Betätigungselements in den mindestens einen weiteren Detektionsbereich erkannt ist. Es wird somit mittels mindestens eines weiteren Leuchtmittels Detektionsstrahlung in einen weiteren Detektionsbereich emittiert, der sich nicht vor dem mindestens einen Bedienelement befindet, wobei die in den weiteren Detektionsbereich emittierte Detektionsstrahlung abweichend von der in den Detektionsbereich emittierten Detektionsstrahlung moduliert wird, die empfangene gestreute/reflektierte Detektionsstrahlung hinsichtlich der Modulation analysiert wird, um den Anteil der in den Detektionsbereich emittierten und reflektierten/gestreuten Detektionsstrahlung und den Anteil der in den weiteren Detektionsbereich emittierten und reflektierten/gestreuten Detektionsstrahlung getrennt zu ermitteln und ein Eindringen des Betätigungselements in den mindestens einen weiteren Detektionsbereich anhand der Intensität des Anteils empfangener/reflektierter Detektionsstrahlung zu erkennen.

Bei einer weiteren Ausführungsform ist die Modulationsvorrichtung ausgebildet, die von dem mindestens einen Leuchtmittel und dem oder den zusätzlichen Leuchtmitteln in den Detektionsbereich emittierte Detektionsstrahlung leuchtmittelindividuell zu modulieren und die Analyseeinheit ausgebildet ist, die empfangene gestreute/reflektierte Detektionsstrahlung hinsichtlich der Modulation leuchtmittelindividuell zu analysieren, um die in den unterschiedlichen Raumbereichen des Detektionsbereichs reflektierten/gestreuten Anteile getrennt zu ermitteln und hieraus eine Position des Betätigungselements vor dem mindestens einen Bedienelement abzuleiten. Diese Information kann verwendet werden, um eine Anpassung der Darstellung verbessert an eine Bedienabsicht des Nutzers anzupassen.

Bei einer Weiterbildung der Erfindung ist vorgesehen, dass die Annäherungserkennungseinheit ausgebildet ist, anhand der zeitlich nacheinander erfassten Positionen des Betätigungselements eine Bewegung des Betätigungselements abzuleiten. Auch diese Information kann verwendet werden, um eine Anpassung der grafischen Anzeige auf dem als Touchscreen ausgebildeten mindestens einen Bedienelement zu verbessern. Ebenso ist es möglich, eine solche Bewegungsinformation zu verwenden, um anhand einer Bewegungsrichtung beispielsweise in einem Fahrzeug, insbesondere einem Kraftfahrzeug, eine Fahrer-Beifahrer-Erkennung auszuführen und/oder zu unterstützen. Geht man davon aus, dass ein Betätigungselement jeweils zunächst in jenen Raumbereich des Detektionsbereichs eindringt, der dem jeweiligen Nutzer am dichtesten benachbart ist, so kann anhand dieser Positions- und/oder Bewegungsinformation eine Nutzererkennung ausgeführt und/oder unterstützt werden.

Als Leuchtmittel eignen sich besonders Leuchtdioden. Besonders bevorzugt werden Leuchtdioden, die Detektionsstrahlung im infraroten Wellenlängenbereich abstrahlen, da dieses für einen Nutzer nicht sichtbar ist.. Die Erfindung sieht vor, dass das mindestens eine zusätzliche Leuchtmittel und/oder die zusätzlichen Leuchtmittel und/oder das mindestens eine weitere Leuchtmittel jeweils mit einer Optik gekoppelt sind, die die Emission der Detektionsstrahlung in einen fächerförmigen Raumbereich lenkt. Besonders bevorzugt umfasst eine solche Optik eine Zylinderlinse, die das emittierte Licht in eine Ebene fokussiert. Um eine fächerförmige Aufweitung in der Ebene gezielt zu erreichen, umfasst die Optik bei einer bevorzugten Ausführungsform zusätzlich ein Umlenkprisma.

Um die gestreute reflektierte Strahlung möglichst effizient auf das Empfangselement, welches vorzugsweise als photoempfindliches Halbleiterelement, besonders bevorzugt als photoempfindliche Diode oder photoempfindlicher Transistor ausgebildet ist, zu lenken, ist vor dem Empfangselement ebenfalls eine Optik, die als Empfangsoptik bezeichnet wird, angeordnet. Diese umfasst bevorzugt eine Zylinderlinse. Die Empfangsoptik ist hiermit so ausgestaltbar, dass sie gestreute/reflektierte Detektionsstrahlung sowohl aus dem Detektionsbereich vor dem mindestens einen Bedienelement als auch aus dem mindestens einen weiteren Detektionsbereich, welcher vor dem mindestens einen weiteren Bedienelement angeordnet ist, gemeinsam empfangen und detektieren kann.

Die unterschiedlichen Leuchtmittel sind besonders bevorzugt auf einer gemeinsamen Trägerplatine angeordnet. Ferner können die verschiedenen Leuchtmittel über eine gemeinsame, vorzugsweise in einer integrierten Schaltung oder einem Chip, ausgebildete Ansteuerelektronik angesteuert werden. Diese Ansteuerelektronik kann so ausgebildet sein, dass die Modulation der Detektionsstrahlung leuchtmittelindividuell ausgeführt wird.

Während es sich als vorteilhaft erwiesen hat, einen ebenenförmig ausgebildeten Detektionsbereich vor dem als Touchscreen ausgebildeten mindestens einen Bedienelement zu verwenden, der einen Winkel von etwa 70° mit einer Ebene der Anzeigefläche einschließt, ist ein weiterer Detektionsbereich, der sich entlang eines seitlichen Randes vor dort angeordneten Bedienelementen erstreckt, ebenfalls ebenenförmig ausgebildet, schließt jedoch einen wesentlich kleineren Winkelbereich relativ zu der Ebene der Anzeigefläche ein.

Um auch in Situationen, in denen der Nutzer im Zuge einer Betätigungshandlung eines anderen Bedienelements und/oder einer sonstigen Handlung über das mindestens eine Bedienelement "hinweggreift", eine Anpassung der grafischen Darstellung auf der Anzeigefläche des als Touchscreen ausgebildeten mindestens einen Bedienelements zu unterdrücken, ist bei einer Ausführungsform der Erfindung vorgesehen, dass die Steuereinheit ausgebildet ist, die Veränderung der Darstellung nach einem Erkennen einer Annäherung des Betätigungselements an das mindestens eine Bedienelement erst nach einem Verstreichen einer vorgegebenen Zeitspanne vorzunehmen, wobei die vorgegebene Zeitspanne einer Zeit entspricht, die bei einer durchschnittlichen Bewegung des Betätigungselements zu dem mindestens einen weiteren Bedienelement zwischen dem Erkennen der Annäherung des Betätigungselements anhand der empfangenen reflektierten und/oder gestreuten in den Detektionsbereich detektierten Detektionsstrahlung an das mindestens eine Bedienelement und dem Erkennen der Annäherung an das mindestens eine weitere Bedienelement anhand der gestreuten und/oder reflektierten in den mindestens einen weiteren Detektionsbereich emittierten Detektionsstrahlung erkannt ist.

Bei anderen Ausführungsformen kann vorgesehen sein, dass benachbart zu den Rändern oder entlang der Ränder angeordneten Bedienelementen weitere Detektionsbereiche vorgesehen sind, in die über Leuchtmittel Detektionsstrahlung emittiert wird, so dass ein Übergreifen dieser Ränder ebenfalls detektiert werden kann. Über eine geeignete Modulation der Detektionsstrahlung ist es jeweils möglich, sämtliche gestreute und/oder reflektierte Detektionsstrahlung mittels des einen Empfangselements nachzuweisen.

Bei einer Ausführungsform ist vorgesehen, dass die weitere Detektionsstrahlung so emittiert wird, dass sich der weitere Detektionsbereich vor mindestens einem weiteren Bedienelement befindet, welches benachbart zu dem mindestens einen Bedienelement angeordnet ist.

Um eine hohe Empfindlichkeit des Empfangselements zu erreichen, ist vor oder um das Empfangselement eine Abschirmung vorgesehen, die eine direkte Einstrahlung von Licht der Leuchtmittel verhindert bzw. unterbindet.

Eine Kompensation hinsichtlich einer an einem Einsatzort, beispielsweise in einem Kraftfahrzeug, existierenden Hintergrundstrahlung im Frequenzbereich der Detektionsstrahlung erfolgt bei einer vorteilhaften Ausführungsform der Erfindung dadurch, dass zeitlich alternierend zu der Emission der Detektionsstrahlung Referenzstrahlung eines Referenzleuchtmittels, welches vorzugsweise identisch wie die übrigen Leuchtmittel ausgebildet ist, über einen festen unveränderlichen Lichtweg auf das Detektionselement geleitet wird. Anhand eines Vergleichs der für die Referenzstrahlung gemessenen Intensität zu unterschiedlichen Detektionszeitpunkten, kann auf eine Änderung der Hintergrundstrahlung geschlossen werden. Eine Ausführungsform der Erfindung sieht vor, dass mittels eines Referenzleuchtmittels zeitlich versetzt zu der Emission der Detektionsstrahlung Referenzstrahlung auf das Empfangselement geleitet wird und aus zu unterschiedlichen Zeitpunkten ermittelter empfangener Referenzstrahlungsintensität ein Hintergrundstrahlungseinfluss ermittelt wird und bei der Ermittlung der Intensität des Anteils der reflektierten und/oder gestreuten Detektionsstrahlung berücksichtigt wird.

Um zusätzlich eine Änderung der Abstrahlungscharakteristik der Leuchtmittel, beispielsweise aufgrund von Temperaturschwankungen, bei einem Dauerbetrieb zu berücksichtigen, werden vorzugsweise zusätzlich Referenzmessungen ausgeführt, wenn keine Annäherung des Betätigungselements erkannt ist.

Die Merkmale des erfindungsgemäßen Verfahrens weisen dieselben Vorteile wie die entsprechenden Merkmale der erfindungsgemäßen Vorrichtung auf.

Nachfolgend wird die Erfindung anhand bevorzugter Ausführungsbeispiele näher erläutert. Hierbei zeigen:

Fig. 1        eine schematische Darstellung einer Bedienvorrichtung mit einer Reflexionslichtschranke;

Fig. 2        eine schematische Explosionszeichnung einer Optikeinheit zum Realisieren einer Reflexionslichtschranke;

Fig. 3        eine schematische Darstellung zur Erläuterung eines Einbaus einer Reflexionslichtschranke benachbart zu einem als Touchscreen ausgebildeten Bedienelement;

Fig. 4        eine schematische Darstellung einer Bedienvorrichtung mit mehreren Detektionsbereichen;

Fig. 5        eine schematische Darstellung einer Bedienvorrichtung, bei der der Detektionsbereich vor dem als Touchscreen ausgebildeten Bedienelement in unterschiedliche Teilbereiche unterteilt ist;

Fig. 6        eine schematische Darstellung ähnlich zu der nach Fig. 4, bei der die Bedienvorrichtung zusätzlich mit einer Nutzererkennungseinrichtung gekoppelt ist.

Fig. 7        eine schematische Darstellung einer Bedienvorrichtung, bei der ein vertikales Übergreifen detektierbar ist;

Fig. 8 u. 9    unterschiedliche schematische Darstellungen von Bedienvorrichtungen, bei denen sowohl ein horizontales als auch ein vertikales Übergreifen detektierbar ist.

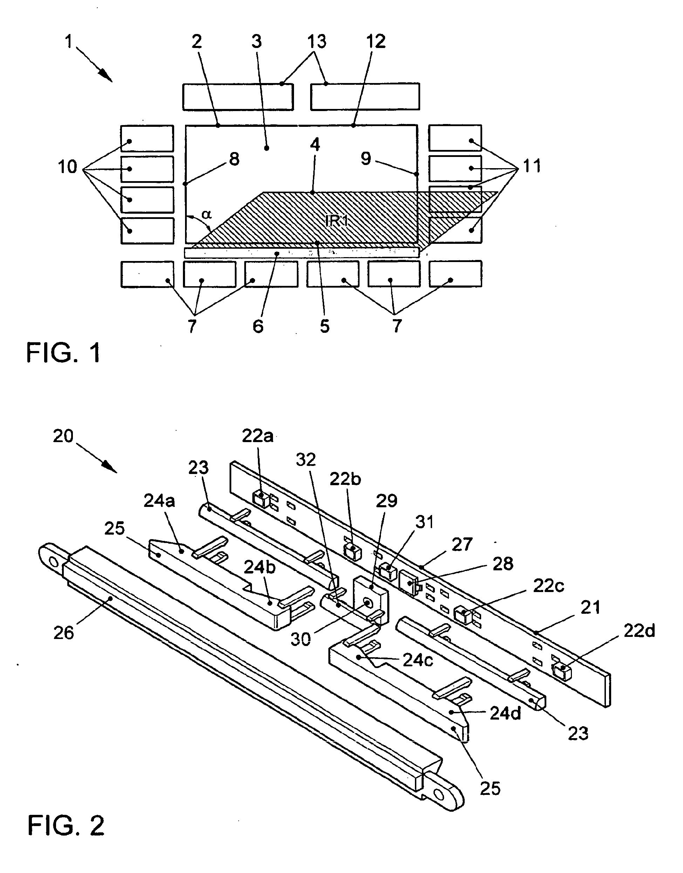

In Fig. 1 ist schematisch eine Bedienvorrichtung 1 mit einer Reflexionslichtschranke dargestellt. Die Bedienvorrichtung umfasst ein als Touchscreen 2 ausgebildetes Bedienelement. Auf einer Anzeigefläche 3 des Touchscreens 2 können grafische Informationen mittels einer Steuereinrichtung zur Anzeige gebracht werden. Um eine grafische Darstellung auf der Anzeigefläche 3 bei einer Annäherung eines Betätigungselements (nicht dargestellt) an den Touchscreen 2 ausführen zu können, ist die Steuereinrichtung mit einer Annäherungserkennungseinrichtung gekoppelt. Die Annäherungserkennungseinrichtung kann zumindest teilweise in die Steuereinrichtung integriert sein. Die Annäherungserkennungseinrichtung emittiert elektromagnetische Detektionsstrahlung, vorzugsweise im infraroten Wellenlängenbereich, in einen räumlich begrenzten in einer Raumebene angeordneten Detektionsbereich 4. Die Abstrahlung der Detektionsstrahlung zum Erzeugen des Detektionsbereichs 4 wird so gewählt, dass in Abhängigkeit von einer Anordnung des Touchscreens 2 relativ zu einem Nutzer ein Betätigungselement, beispielsweise eine Hand, des Nutzers bei einer berührenden Betätigung des Touchscreens 2 in den Detektionsbereich 4 eindringt oder diesen vor einer berührenden Betätigung durchdringt.

Bei der dargestellten Ausführungsform der Bedienvorrichtung 1 schließt eine Ebene, in der der Detektionsbereich 4 angeordnet ist, mit einer Ebene der Anzeigefläche 3 einen Winkel $\alpha$ ein, der kleiner als 90° ist. Vorzugsweise beträgt der Winkel $\alpha$ etwa 75°. Die Detektionsstrahlung wird benachbart zu einem unteren Rand 5 der Anzeigefläche 3 des Touchscreens 2 in den Raum vor dem Touchscreen emittiert. Unterhalb des unteren Randes 5 und unterhalb eines Emmissionsfensters 6, welches für die Detektionsstrahlung transparent ist, sind als Tastschalter ausgebildete zusätzliche Bedienelemente 7 vorgesehen. Dadurch, dass der Detektionsbereich 4 der Reflexionslichtschranke nicht entlang einer Oberflächennormale jener Ebene emittiert wird, in der auch die zusätzlichen Bedienelemente 7 angeordnet sind, können diese durch ein Betätigungselement berührend bedient werden, ohne dass dieses Betätigungselement in den Detektionsbereich 4 der Reflexionslichtschranke eintritt und diese auslöst. Dieses ist beispielsweise vorteilhaft bei einer Anordnung der Bedienvorrichtung 1 in einer Mittelkonsole eines Kraftfahrzeugs. Die zusätzlichen Bedienelemente 7 können durch das Betätigungselement des Nutzers bedient werden, ohne dass dieses in den Detektionsbereich 4 der Reflexionslichtschranke eindringt. Durch geeignete Wahl des Winkels a lässt sich dieses für unterschiedliche Einbauhöhen relativ zu einer Sitzflächenhöhe des Sitzes realisieren, auf dem der oder die Nutzer sitzen. Benachbart zu seitlichen Rändern 8, 9 sind weitere Bedienelemente 10, 11 angeordnet. Ferner sind oberhalb eines oberen Randes 12 der Anzeigefläche 3 des Touchscreens 2 wieder weitere Bedienelemente 13 angeordnet.

In Fig. 2 ist schematisch eine Explosionszeichnung einer Optikeinheit 20 einer Reflexionslichtschranke dargestellt. Auf einer Trägerplatine 21 sind Leuchtmittel 22a-22d zum Emittieren von Detektionsstrahlung im Wesentlichen gleich beabstandet voneinander angeordnet. Die Leuchtmittel 22a-22d sind vorzugsweise als im infraroten Wellenlängenbereich strahlende Leuchtdioden ausgebildet. Vor den Leuchtmitteln 22a-22d sind Zylinderlinsen 23 angeordnet. Diese bewirken eine Fokussierung der Detektionsstrahlung in eine Ebene. Um eine Aufweitung der Detektionsstrahlung über einen Winkelbereich innerhalb der Detektionsebene zu erreichen, sind Umlenkprismen 24a-24d vorgesehen, von denen jeweils zwei in Optikelementen 25 zusammengefasst sind. Abgeschlossen wird die Optikeinheit 20 durch eine Abschlussblende bzw. ein Emissionsfenster 26. Dieses ist transparent im Wellenlängen- bzw. Frequenzbereich der Detektionsstrahlung. In einer Mitte 27 der Trägerplatine 21 ist ein vorzugsweise als Fotodiode ausgebildetes Empfangselement 28 angeordnet. Um eine direkte Einstrahlung oder ein Auffangen von Streustrahlung der Leuchtmittel 22a-22d zu verhindern, ist über dem Empfangselement 28 eine Abschirmung 29 angeordnet, die eine Eintrittsöffnung 30 umfasst. Unterhalb der Abschirmung 29 befindet sich gemeinsam mit dem Empfangselement 28 ein Referenzleuchtmittel 31, welches vorzugsweise identisch zu den Leuchtmitteln 22a-22d ausgebildet ist. Dieses ist vorgesehen, um zeitlich alternierend zu den Leuchtmitteln 22a-22d Referenzstrahlung im selben Wellenlängen- bzw. Frequenzbereich wie die Leuchtmittel 22a-22d zu emittieren und hierüber eine Kompensation hinsichtlich einer Hintergrundstrahlung am Einsatzort, beispielsweise in einem Fahrzeug, zu ermöglichen.

Vor der Eintrittsöffnung 30 der Abschirmung 29 ist eine weitere Zylinderlinse 32 vorgesehen, die an einem Betätigungselement gestreute und/oder reflektierte Detektionsstrahlung der Leuchtmittel 22a-22d, die durch das Emissionsfenster 26 hindurchgetreten ist, auf das Empfangselement 28 zu fokussieren.

Die in Fig. 2 dargestellte Optikeinheit 20 ist um eine Ansteuerelektronik ergänzt, die auf der Trägerplatine 21 oder getrennt ausgebildet sein kann. Vorzugsweise ist diese in einer integrierten Schaltung ausgeführt und in der Lage, die Leuchtmittel 22a-22d sowie das Referenzleuchtmittel 31 anzusteuern. Hierbei ist es vorzugsweise möglich, die von den einzelnen Leuchtmitteln 22a-22d und dem Referenzleuchtmittel 31 emittierte Detektionsstrahlung bzw. Referenzstrahlung leuchtmittelindividuell, vorzugsweise frequenzmoduliert, zu erzeugen. Die Annäherungserkennungseinheit umfasst ferner eine Auswertelektronik, die die empfangene gestreute/reflektierte Detektionsstrahlung und/oder Referenzstrahlung hinsichtlich der Intensität auswertet. Die Auswerte- und Ansteuerelektronik der Annäherungserkennungseinheit kann bei einigen Ausführungsformen in eine Steuereinrichtung integriert sein, die eine grafische Darstellung auf der Anzeigefläche 3 eines als Touchscreen ausgebildeten Bedienelement steuert.

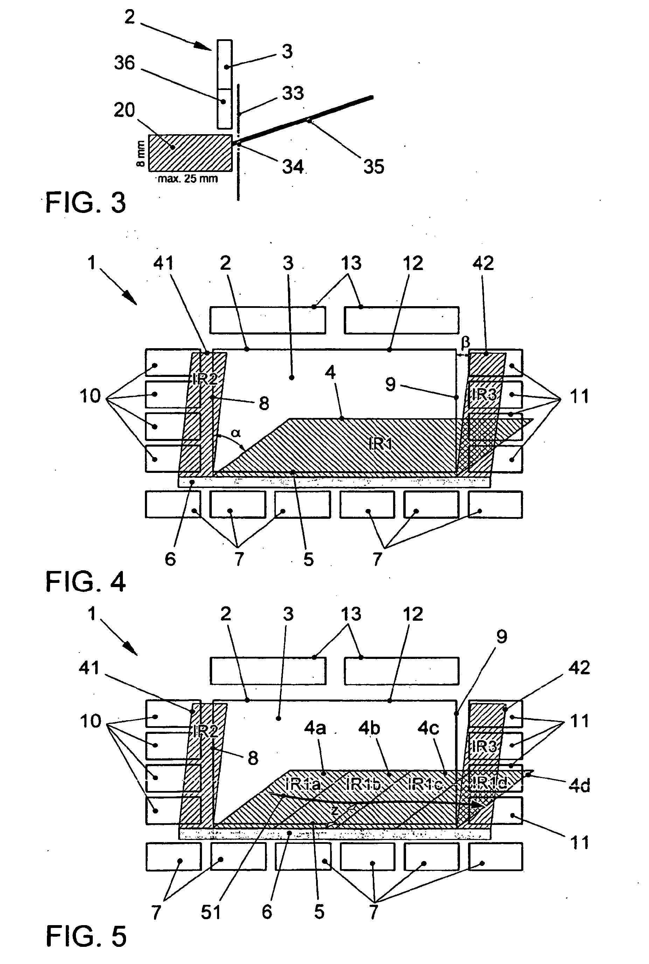

In Fig. 3 ist schematisch ein Einbau einer Optikeinheit 20 ähnlich zu der nach Fig. 2 benachbart zu einem Touchscreen 2 schematisch dargestellt. Die Optikeinheit 20 ist unterhalb eines Displayrahmens 36, der eine aktive Anzeigefläche 3 des Touchscreens 2 umgibt, angeordnet. Sowohl der Displayrahmen 36 als auch die Optikeinheit 20 sind durch eine Abdeckblende 33 abgedeckt, die zumindest einen Austritts- oder Fensterbereich 34 für die Detektionsstrahlung 35 umfasst. Die Abdeckung 33 mit dem Fensterbereich 34 kann das Emissionsfenster 26 der Optikeinheit 20 nach Fig. 2 ersetzen. Die Optikeinheit 20 ist vorzugsweise so ausgebildet, dass sie Justageelemente (nicht dargestellt) umfasst, die eine Ausrichtung der Optikeinheit relativ zu einer Ebene der Anzeigefläche 3 des Touchscreens 2 ermöglichen. Ferner ist die Optik der Optikeinheit 20 vorzugsweise so ausgebildet, dass die Detektionsstrahlung nicht lotrecht zu einer Ebene der Trägerplatine, sondern angewinkelt hierzu in einer Ebene emittiert wird, die einen Winkel $\alpha$ kleiner 90° mit der Anzeigefläche 3 einschließt.

In Fig. 4 ist eine weitere Ausführungsform einer Bedienvorrichtung 1 ähnlich zu der nach Fig. 1 dargestellt, bei der jedoch zusätzlich zu dem Detektionsbereich 4 vor der Anzeigefläche 3 des Touchscreens 2 weitere Detektionsbereiche 41 und 42 ausgebildet sind, die entsprechend vor den weiteren Bedienelementen 10 und 11 ausgebildet sind.

Die weiteren Detektionsbereiche 41, 42 sind in einer Raumebene ausgebildet, die relativ zu der Ebene der Anzeigefläche 3 des Touchscreens 2 einen Winkel β einschließt, welcher kleiner als der Winkel α ist, den die Ebene, in der der Detektionsbereich 4 liegt, und die Ebene der Anzeigefläche 3 einschließen. Die weiteren Leuchtmittel, die Detektionsstrahlung in die weiteren Detektionsbereiche 41, 42 emittieren, sind vorteilhafterweise auf derselben Trägerplatine wie jene Leuchtmittel angeordnet, die Detektionsstrahlung in den Detektionsbereich 4 emittieren.

Um die an einem Betätigungselement reflektierte Detektionsstrahlung, die von dem Empfangselement der Annäherungserkennungseinrichtung aufgefangen wird, den einzelnen Detektionsbereichen 4, 41, 42 zuordnen zu können, ist die Detektionsstrahlung, welche in die unterschiedlichen Detektionsbereiche 4, 41, 42 emittiert wird, zumindest detektionsbereichindividuell moduliert. Über eine Analyse der Modulation der empfangenen Detektionsstrahlung ist somit eine Zuordnung zu den einzelnen Detektionsbereichen 4, 41, 42 möglich. Hierdurch wird es möglich, Betätigungssituationen zu unterscheiden, in denen sich ein Betätigungselement des Nutzers an den Touchscreen 2 annähert, jedoch eine über den Touchscreen 2 erfassbare Betätigungshandlung nicht vorgenommen werden soll, sondern vielmehr eines der weiteren Bedienelemente 10, 11 betätigt werden soll. In einem solchen Fall ist es wünschenswert, dass eine Anpassung der Darstellung auf der Anzeigefläche 3 des Touchscreens 2 unterbleibt. Betätigt beispielsweise ein links von der Anzeigefläche 3 des Touchscreens 2 sitzender Nutzer eines der rechts von dem seitlichen Rand 9 der Anzeigefläche 3 angeordneten Bedienelemente 11, so dringt das Betätigungselement sowohl in den Detektionsbereich 4 als auch den weiteren Detektionsbereich 42 ein. Über eine geeignete logische Verknüpfung kann die Annäherungserkennungseinheit und/oder die Steuereinheit eine solche Situation erkennen und eine Anpassung der Darstellung unterdrücken bzw. unterlassen. Eine Unterdrückung soll beispielsweise in einer Situation stattfinden, in der eine Annäherung sowohl an den Touchscreen 2 als auch eine Annäherung an eines der weiteren Bedienelemente 11 erkannt worden ist und zusätzlich die Annährung an den Touchscreen vor eine Annäherung an die weiteren Bedienelemente 11 erkannt worden ist. Ordnet man den einzelnen Detektionsbereichen 4, 41, 42 in dieser Reihenfolge die logischen Variablen IR1, IR2, IR3 zu und bezeichnet mit T(IRX) den Zeitpunkt, zu dem eine Annäherung in den Detektionsbereich IRX erkannt ist, zu, so lässt sich die logische Bedingung formulieren als:

$$(IR1 \ \& \ IR3 = wahr) \ \& \ (T(IR1) < T(IR3)).$$

Entsprechend würde eine Unterdrückung bei einer Betätigung durch einen rechts von dem Touchscreen 2 angeordneten Beifahrer unterbleiben, wenn folgende logische Bedingung erfüllt ist:

$$(IR1 \ \& \ IR2 = wahr) \ \& \ (T(IR1) < T(IR2)).$$

In Fig. 5 ist eine weitere Ausführungsform dargestellt, bei der der Detektionsbereich 4 in Unterbereiche 4a-4d unterteilt ist, denen die logischen Variabeln IR1a-IR1d zugeordnet sind. In jeden der Unterbereiche 4a-4d wird jeweils von einem der Leuchtmittel Detektionsstrahlung emittiert, wobei die Detektionsstrahlung in den unterschiedlichen Unterbereichen 4a-4d jeweils unterschiedlich moduliert ist. Hierdurch ist es möglich, eine Position des Betätigungselements innerhalb des Detektionsbereichs 4 anhand der empfangenen den einzelnen Unterbereichen 4a-4d zuordenbaren Anteile zu ermitteln. Anhand einer zeitaufgelösten Auswertung kann zusätzlich eine Bewegung eines Betätigungselements ermittelt werden. Anhand der dem einzelnen Unterbereich 4a-4d zugeordneten Intensitätsanteil der Detektionsstrahlung kann jeweils auf einen Abstand bzw. einen Anteil der Reflexionsfläche des Betätigungselements in dem entsprechenden Unterbereich 4a-4d geschlossen werden. Anhand einer zeitaufgelösten Analyse kann dann auch eine Bewegungsrichtung ermittelt werden, wie dies durch einen Pfeil 51 in Fig. 5 angedeutet ist.

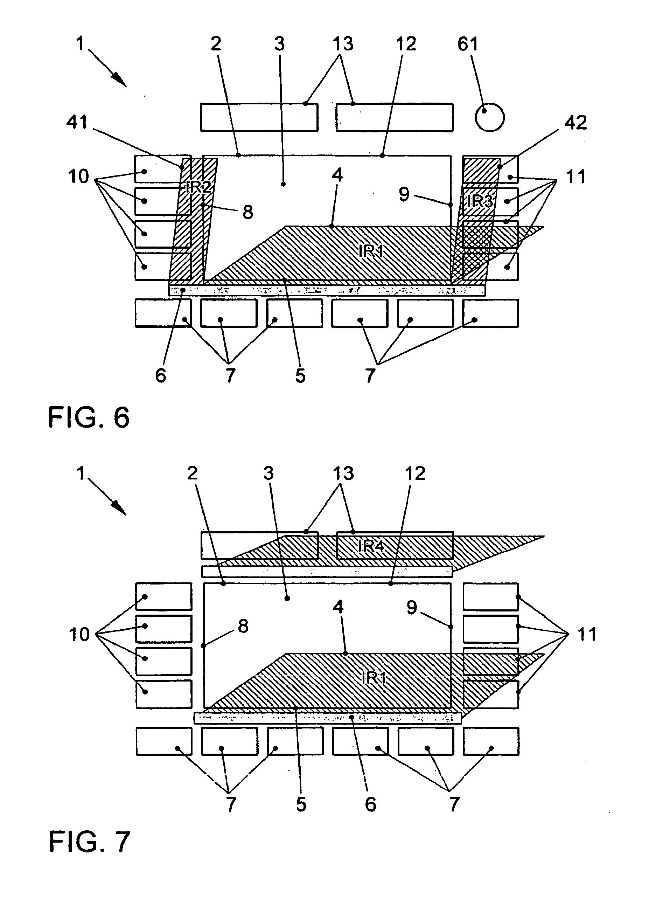

In Fig. 6 ist schematisch eine Ausführungsform dargestellt, die der nach Fig. 4 ähnelt. Zusätzlich ist schematisch eine weitere Empfangseinheit 61 dargestellt, welche ausgebildet ist, in den Nutzer eingekoppelte Hochfrequenzsignale kapazitiv zu erfassen. Hierdurch ist es eindeutig möglich, beispielsweise in einem Fahrzeug, insbesondere einem Kraftfahrzeug, eine Fahrer-Beifahrererkennung auszuführen. Bei einer solchen Ausführungsform wird eine Anpassung der Darstellung auf der Anzeigefläche 3 des Touchscreens 2 unterdrückt, wenn gilt:

$$(IR1 \ \& \ IR3 = wahr) \ \& \ (F = wahr) \ oder \ (IR1 \ \& \ IR2 = wahr) \ \& \ (B = wahr),$$

wobei F und B den Fahrer bzw. Beifahrer repräsentieren. Selbstverständlich können auch beliebige andere Systeme zur Fahrer/Beifahrererkennung genutzt werden.

In Fig. 7 ist eine Ausführungsform einer Bedienvorrichtung dargestellt, bei der eine Unterdrückung einer Anpassung der Darstellung auf der Anzeigefläche 3 des Touchscreens 2 bei einem vertikalen Übergreifen unterdrückt werden kann, beispielsweise wenn die Bedienelemente 13 betätigt werden. Hierfür ist vorgesehen, dass zwischen dem oberen Rand 12 und den Bedienelementen 13 Detektionsstrahlung in einen Detektionsbereich 71 emittiert wird, der vorzugsweise in einer Ebene liegt, welche lotrecht zu der Anzeigefläche 3 des Touchscreens 2 ausgebildet ist. Wird eine Anwesenheit in dem Detektionsbereich 4 und dem zusätzlichen Detektionsbereich 71 erfasst, wobei ein Eindringen in den Detektionsbereich 4 vor einem Eindringen in den zusätzlichen Detektionsbereich 71 erfolgt, so wird eine Änderung der Darstellung unterdrückt. In Kurzschreibung lautet die logische Bedingung:

$$(IR1 \ \& \ IR4 = wahr) \ \& \ (T(IR1) < T(IR4)),$$

wobei dem zusätzlichen Detektionsbereich 71 die logische Variable IR4 zugeordnet ist.

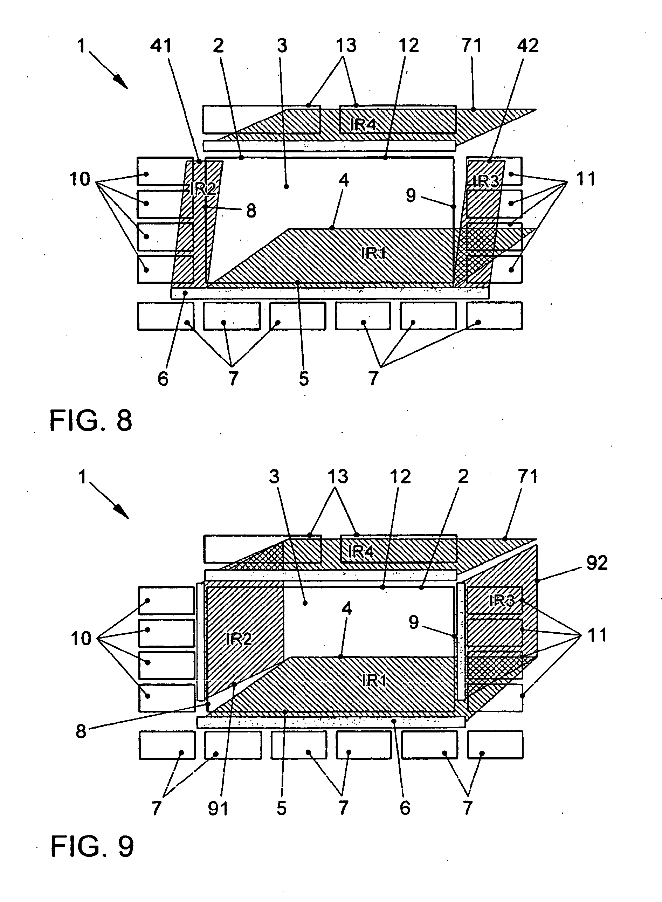

In Fig. 8 ist eine Bedienvorrichtung 1 dargestellt, die einer Kombination der Ausführungsformen nach Fig. 4 und 7 entspricht. In Fig. 9 ist ferner eine Ausführungsform dargestellt, bei der die weiteren Detektionsbereiche 41, 42 nach Fig. 3 entsprechenden Detektionsbereiche 91, 92 nicht durch Detektionsstrahlung gebildet sind, welches benachbart zu dem unteren Rand 5 der Anzeigefläche seitlich von der Anzeigefläche 3 emittiert wird. Vielmehr wird Detektionsstrahlung benachbart zu den seitlichen Rändern 8, 9 jeweils lotrecht zu der Anzeigefläche 3 emittiert. Hierdurch werden die Detektionsbereiche 91, 92 gebildet, welchen die logischen Bezeichnungen IR2 und IR3 entsprechend zugeordnet sind. Bei den Ausführungsformen nach Fig. 8 und 9 erfolgt eine Unterdrückung, wenn eine der folgenden logischen Bedingungen erfüllt ist:

$$(IR1 \ \& \ IR4 = wahr) \ \& \ (T(IR1) < T(IR4)),$$

dies entspricht einer Bedienung eines der Bedienelemente 13 oberhalb des oberen Rands 12 der Anzeigefläche 3, oder

$$(IR1 \ \& \ IR3 = wahr) \ \& \ (T(IR1) < T(IR3)),$$

dies entspricht einer Bedienung der weiteren Bedienelemente 11 beispielsweise durch einen Fahrer, welcher links von der Anzeigefläche 3 angeordnet ist, oder

$$(IR1 \ \& \ IR2 = wahr) \ \& \ (T(IR1) < T(IR2)),$$

dies entspricht einer Bedienung der links von der Anzeigefläche 3 angeordneten weiteren Bedienelemente 8 beispielsweise durch einen rechts von der Anzeigefläche 3 angeordneten Beifahrer.

Es ergibt sich für den Fachmann, dass hier lediglich beispielhafte Ausführungsformen beschrieben worden sind. Die einzelnen Merkmale der beschriebenen Ausführungsformen können in beliebiger Kombination verwendet werden, um die Erfindung auszuführen.

Bezugszeichenliste

1             Bedienvorrichtung

| | |
|---|---|
| 2 | Touchscreen |
| 3 | Anzeigefläche |
| 4 | Detektionsbereich |
| $\alpha$ | Winkel zwischen der Ebene, in der der Detektionsbereich 4 liegt, und einer Ebene der Anzeigefläche 3 |
| 5 | unterer Rand |
| 6 | Emmissionsfenster |
| 7 | zusätzliche Bedienelemente |
| 8, 9 | seitliche Ränder |
| 10, 11 | weitere Bedienelemente |
| 12 | oberer Rand |
| 13 | wieder weitere Bedienelemente |
| 20 | Optikeinheit |
| 21 | Trägerplatine |
| 22a-22d | Leuchtelemente |
| 23 | Zylinderlinse |
| 24a-24d | Umlenkprisma |
| 25 | Optikelemente |
| 26 | Emissionsfenster |
| 27 | Mitte |
| 28 | Empfangselement |
| 29 | Abschirmung |
| 30 | Eintrittsöffnung |
| 31 | Referenzleuchtmittel |
| 32 | weitere Zylinderleise |
| 33 | Abdeckblech |
| 34 | Austritts- oder Fensterbereich |
| 35 | Detektionsstrahlung |
| 36 | Displayrahmen |
| 41, 42 | weitere Detektionsbereiche |

| 51 | Pfeil |
|---|---|
| 61 | weitere Empfangseinheit |
| 71 | Detektionsbereich |
| 91, 92 | weitere Detektionsbereiche |
| β | eingeschlossener Winkel zwischen einer Ebene der weiteren Detektionsbereiche 41, 42 und einer Ebene der Anzeigefläche 3 |

**Patentansprüche**

1. Bedienvorrichtung (1) umfassend mindestens ein Bedienelement zum Erfassen von Nutzereingaben und eine Annäherungserkennungseinrichtung, die ausgebildet ist, eine Annäherung eines Betätigungselements, insbesondere eines Körperteils, eines Nutzers an das Bedienelement vor einer Berührung des mindestens einen Bedienelements zu erfassen,
wobei die Annäherungserkennungseinrichtung eine Reflexionslichtschranke umfasst, die mindestens ein Leuchtmittel (22a-22d) zum Emittieren von elektromagnetischer Detektionsstrahlung (35) vor das mindestens eine Bedienelement in einen räumlich begrenzten Detektionsbereich (4), der nicht ein gesamtes Volumen vor dem mindestens einen Bedienelement umfasst, und ein Empfangselement (28) zum Detektieren eines an dem Betätigungselement des Nutzers bei einer Annäherung an das mindestens eine Bedienelement gestreuten und/oder reflektierten Anteils der Detektionsstrahlung (35) aufweist, wobei die Annäherungserkennungseinrichtung ausgebildet ist, eine Annäherung anhand einer Intensität der empfangenen Detektionsstrahlung zu erkennen
**dadurch gekennzeichnet, dass**
das mindestens eine Leuchtmittel (22a-22d) mit einer Optik gekoppelt ist, die die Emission der Detektionsstrahlung in einen fächerförmigen Raumbereich lenkt.

2. Bedienvorrichtung (1) nach Anspruch 1, **dadurch gekennzeichnet, dass** das mindestens eine Bedienelement ein Touchscreen (2) ist, der mit einer Steuereinrichtung verknüpft ist, die bei einer erkannten Annäherung des Betätigungselements eine grafische Darstellung auf einer Anzeigefläche (3) des Touchscreens (2) verändert.

3. Bedienvorrichtung (1) nach Anspruch 2, **dadurch gekennzeichnet, dass** zum Erfassen der Nutzereingaben mindestens ein zusätzliches Bedienelemente (7) vorgesehen ist, das benachbart zu einem Rand (5) der Anzeigefläche (3) des Touchscreens (2) angeordnet ist, wobei die Detektionsstrahlung des mindestens einen Leuchtmittels (22a-22d) zwischen dem Rand (5) des Touchscreens (2) und dem mindestens einen zusätzlichen Bedienelement (7) in den Detektionsbereich (4) emittiert wird, der in einer Detektionsebene liegt, wobei die Detektionsebene und eine Ebene der Anzeigefläche (3) einen Winkel (α) kleiner 90° einschließen, so dass eine Betätigung des mindestens einen zusätzlichen Bedienelements (7) möglich ist, ohne mit dem Betätigungselement in den Detektionsbereich (4) einzudringen.

4. Bedienvorrichtung (1) nach einem der vorangehenden Ansprüche, **dadurch gekennzeichnet, dass** die Annäherungserkennungseinrichtung ein oder mehrere zusätzliche Leuchtmittel (22a-22d) umfasst, die ausgebildet sind, Detektionsstrahlung in den Detektionsbereich (4) zu emittieren, wobei das mindestens eine Leuchtmittel (22a-22d) und das oder die zusätzlichen Leuchtmittel (22a-22d) jeweils ihre Detektionsstrahlung in unterschiedliche Raumbereiche (4a-4d) des Detektionsbereichs (4) emittieren.

5. Bedienvorrichtung (1) nach Anspruch 4, **dadurch gekennzeichnet, dass** die Annäherungserkennungseinrichtung mindestens eine weiteres Leuchtmittel zum Emittieren von elektromagnetischer Detektionsstrahlung in einen von dem Detektionsbereich (4) verschiedenen weiteren Detektionsbereich (41, 42), mindestens eine Modulationsvorrichtung zum Modulieren der emittierten Detektionsstrahlung mindestens eines der Leuchtmittel, so dass sich zumindest die in den mindestens einen weiteren Detektionsbereich (41, 42) emittierte weitere Detektionsstrahlung von der in den Detektionsbereich (4) emittierten Detektionsstrahlung hinsichtlich ihrer Modulation unterscheidet, und eine Analyseeinheit umfasst, die ausgebildet ist, die empfangene reflektierte und/oder gestreute Detektionsstrahlung hinsichtlich ihrer Modulation zu analysieren, um zumindest einen gestreuten/reflektierten Anteil der in den weiteren Detektionsbereich (41, 42) emittierten Detektionsstrahlung getrennt von dem gestreuten und/oder reflektierten Anteil der in den Detektionsbereich (4) emittierten Detektionsstrahlung zu ermitteln und ein Eindringen des Betätigungselements in den mindestens einen weiteren Detektionsbereich (41, 42) anhand der Intensität des Anteils an empfangener reflektierter und/oder gestreuter in diesen mindestens einen weiteren Detektionsbereich (41, 42) emittierten Detektionsstrahlung zu erkennen.

6. Bedienvorrichtung (1) nach einem der vorangehenden Ansprüche, **dadurch gekennzeichnet, dass** die Steuereinheit ausgebildet ist, die Veränderung der Darstellung zu unterlassen, wenn zusätzlich zu der Annäherung an das mindestens eine Bedienelement ein Eindringen des Betätigungselements in den mindestens einen weiteren Detektionsbereich (41, 42) erkannt ist.

7. Bedienvorrichtung (1) nach einem der Ansprüche 5 oder 6, **dadurch gekennzeichnet, dass** die Modulationsvorrichtung ausgebildet ist, die von dem mindestens einen Leuchtmittel (22a-22d) und dem oder den zusätzlichen Leuchtmitteln (22a-22d) in den Detektionsbereich emittierte Detektionsstrahlung (35) leuchtmittelindividuell zu modulieren und die Analyseeinheit ausgebildet ist, die empfangene gestreute und/oder reflektierte Detektionsstrahlung hinsichtlich der Modulation leuchtmittelindividuell zu analysieren, um die in den unterschiedlichen Raumbereichen (4a-4d) des Detektionsbereichs (4) reflektierten/gestreuten Anteile getrennt zu ermitteln und hieraus eine Position des Betätigungselements vor dem mindestens einen Bedienelement abzuleiten.

8. Bedienvorrichtung (1) nach einem der vorangehenden Ansprüche, **dadurch gekennzeichnet, dass** die Annäherungserkennungseinheit ausgebildet ist, anhand der zeitlich nacheinander erfassten Positionen des Betätigungselements, eine Bewegung des Betätigungselements abzuleiten.

9. Bedienvorrichtung (1) nach einem der vorangehenden Ansprüche, **dadurch gekennzeichnet, dass** die Optik eine Zylinderlinse (23) zum Fokussieren der Detektionsstrahlung in eine Raumebene umfasst.

10. Bedienvorrichtung (1) nach einem der vorangehenden Ansprüche, **dadurch gekennzeichnet, dass** die Optik ein Umlenkprisma (24a-24d) umfasst, um eine Auffächerung der Detektionsstrahlung (35) in einem Winkelbereich in einer Raumebene zu bewirken.

11. Bedienvorrichtung (1) nach einem der vorangehenden Ansprüche, **dadurch gekennzeichnet, dass** die Steuereinheit ausgebildet ist, die Veränderung der Darstellung nach einem Erkennen der Annäherung des Betätigungselements an das mindestens eine Bedienelement erst nach einem Verstreichen einer vorgegebenen Zeitspanne vorzunehmen, wobei die vorgegebene Zeitspanne einer Zeit entspricht, die bei einer durchschnittlichen Bewegung des Betätigungselements zu mindestens einem weiteren Bedienelement (11) zwischen dem Erkennen der Annäherung des Betätigungselements anhand der empfangenen reflektierten und/oder gestreuten in den Detektionsbereich (4) emittierten Detektionsstrahlung an das mindestens eine Bedienelement und dem Erkennen der Annäherung an das mindestens eine weitere Bedienelement (11) anhand der gestreuten und/oder reflektierten in den mindestens einen weiteren Detektionsbereich (42) emittierten Detektionsstrahlung erkannt ist, wobei eine Betätigung des mindestens einen weiteren Bedienelements in der Regel ohne ein Eindringen des Betätigungselements in den Detektionsbereich vor dem mindestens einen Bedienelement nicht möglich ist.

12. Verfahren zum Betreiben einer Bedienvorrichtung (1), wobei die Bedienvorrichtung (1) mindestens ein Bedienelement zum Erfassen von Nutzereingaben und eine Annäherungserkennungseinrichtung umfasst, die eine Annäherung eines Betätigungselements, insbesondere eines Körperteils, eines Nutzers an das Bedienelement vor einer Berührung des Bedienelements erfasst,
wobei mittels mindestens eines Leuchtmittels (22a-22d) elektromagnetische Detektionsstrahlung in einen räumlich begrenzten Detektionsbereich (4) vor das Bedienelement emittiert wird, wobei der Detektionsbereich (4) nicht ein gesamtes Volumen vor dem mindestens einen Bedienelement umfasst, und mittels eines Empfangselements (28) bei einer Annäherung des Betätigungselement des Nutzers an das mindestens eine Bedienelement ein an dem Betätigungselement gestreuter und/oder von diesem Betätigungselement reflektierter Anteil der Detektionsstrahlung empfangen wird und anhand einer Intensität des empfangenen Anteils der Detektionsstrahlung die Annäherung erkannt wird,
**dadurch gekennzeichnet, dass**
die Detektionsstrahlung (35) des mindestens einen Leuchtmittels (22a-22d) mittels einer Optik in einen fächerförmigen Raumbereich emittiert wird.

13. Verfahren nach Anspruch 12, **dadurch gekennzeichnet, dass** das mindestens eine Bedienelement ein Touchscreen (2) ist und bei einer erkannten Annäherung eine Anpassung der Darstellung auf dem Touchscreen (2) vorgenommen wird und die Detektionsstrahlung (35) des mindestens einen Leuchtmittels (22a-22d) benachbart zu einem Rand (5) einer Anzeigefläche (3) des Touchscreens (2) in einen in einer Detektionsebene liegenden Detektionsbereich (4) emittiert wird, wobei die Detektionsebene und eine Ebene der Anzeigefläche (3) einen Winkel ($\alpha$) kleiner 90° einschließen.

**14.** Verfahren nach einem der Ansprüche 12 oder 13, **dadurch gekennzeichnet, dass** mittels mindestens eines weitern Leuchtmittels Detektionsstrahlung in einen weiteren Detektionsbereich (41, 42) emittiert wird, der sich nicht vor dem mindestens einen Bedienelement befindet, wobei die in den weiteren Detektionsbereich (41, 42) emittierte Detektionsstrahlung abweichend von der in den Detektionsbereich (4) emittierten Detektionsstrahlung moduliert wird, und die empfangene gestreute Detektionsstrahlung hinsichtlich der Modulation analysiert wird, um den Anteil der in den Detektionsbereich (4) emittierten und reflektierten/gestreuten Detektionsstrahlung (35) und den Anteil der in den weiteren Detektionsbereich (41, 42) emittierten und reflektierten/gestreuten Detektionsstrahlung getrennt zu ermitteln, und ein Eindringen des Betätigungselements in den mindestens einen weiteren Detektionsbereich (41, 42) anhand der Intensität des Anteils an empfangener reflektierter/gestreuter weiterer Detektionsstrahlung erkannt wird.

**15.** Verfahren nach einem der Ansprüche 12 bis 14, **dadurch gekennzeichnet, dass** in den Detektionsbereich (4) zusätzlich zu der Detektionsstrahlung zusätzliche Detektionsstrahlung zusätzlicher Leuchtmittel (22a-22d) emittiert wird, wobei das mindestens eine Leuchtmittel (22a-22d) und die zusätzlichen Leuchtmittel (22a-22d) die Detektionsstrahlung in jeweils voneinander verschiedene Teilbereiche (4a-4d) des Detektionsbereichs (4) emittieren und die Detektionsstrahlung und die zusätzliche Detektionsstrahlung leuchtmittelindividuell moduliert werden und die empfangene gestreute und/oder reflektierte Detektionsstrahlung hinsichtlich der Modulationen ausgewertet wird, um die gestreuten und/oder reflektierten Anteile leuchtmittelindividuell zu ermitteln, und hieraus eine Position des Betätigungselement abgeleitet wird.

## Claims

**1.** Operator control apparatus (1) comprising at least one operator control element for capturing user inputs and an approach detection device which is designed to sense an approach by an activation element, in particular a body part, of a user to the operator control element before the at least one operator control element is touched, wherein the approach detection device comprises a reflection light barrier which comprises at least one lighting means (22a-22d) for emitting electromagnetic detection radiation (35) in front of the at least one operator control element into a spatially limited detection region (4) which does not comprise an entire volume in front of the at least one operator control element, and a receiver element (28) for detecting a portion of the detection radiation (35) which is scattered and/or reflected at the activation element of the user when the at least one operator control element is approached, wherein the approach detection device is designed to detect an approach on the basis of the intensity of the received detection radiation,
**characterized in that**
the at least one lighting means (22a-22d) is coupled to an optical device which deflects the emission of the detection radiation into a fan-shaped spatial region.

**2.** Operator control apparatus (1) according to Claim 1, **characterized in that** the at least one operator control element is a touchscreen (2) which is linked to a control apparatus which changes a graphic representation on a display surface (3) of the touchscreen (2) when an approach by the activation element is detected.

**3.** Operator control apparatus (1) according to Claim 2, **characterized in that** in order to capture the user inputs at least one additional operator control element (7) is provided which is arranged adjacent to an edge (5) of the display surface (3) of the touchscreen (2), wherein the detection radiation of the at least one lighting means (22a-22d) is emitted between the edge (5) of the touchscreen (2) and the at least one additional operator control element (7), into the detection region (4) which is in a detection plane, wherein the detection plane and a plane of the display surface (3) enclose an angle ($\alpha$) of less than 90°, with the result that activation of the at least one additional operator control element (7) is possible without the activation element penetrating the detection region (4).

**4.** Operator control apparatus (1) according to one of the preceding claims, **characterized in that** the approach detection device comprises one or more additional lighting means (22a-22d) which are designed to emit detection radiation into the detection region (4), wherein the at least one lighting means (22a-22d) and the additional lighting means (22a-22d) respectively emit their detection radiation into different spatial regions (4a-4d) of the detection region (4).

5. Operator control apparatus (1) according to Claim 4, **characterized in that** the approach detection device comprises at least one further lighting means for emitting electromagnetic detection radiation into a further detection region (41, 42) which is different from the detection region (4), at least one modulation device for modulating the emitted detection radiation of at least one of the lighting means, with the result that at least the further detection radiation which is emitted into the at least one further detection region (41, 42) differs from the detection radiation emitted into the detection region (4) in terms of its modulation, and an analysis unit which is designed to analyze the received reflected and/or scattered detection radiation in terms of its modulation, in order to determine at least one scattered/reflected portion of the detection radiation emitted into the further detection region (41, 42), separately from the scattered and/or reflected portion of the detection radiation emitted into the detection region (4), and to detect penetration of the activation element into the at least one further detection region (41, 42) on the basis of the intensity of the proportion of received reflected and/or scattered detection radiation emitted into this at least one further detection region (41, 42).

6. Operator control apparatus (1) according to one of the preceding claims, **characterized in that** the control unit is designed to fail to change the representation if, in addition to the approach to the at least one operator control element, penetration of the actuation element into the at least one further detection region (41, 42) is detected.

7. Operator control apparatus (1) according to either of Claims 5 and 6, **characterized in that** the modulation apparatus is designed to modulate on a lighting-means-specific basis the detection radiation (35) emitted into the detection region by the at least one lighting means (22a-22d) and the additional lighting means (22a-22d), and the analysis unit is designed to analyze the received scattered and/or reflected detection radiation in terms of the modulation on a lighting-means-specific basis, in order to determine separately the portions reflected/scattered in the different spatial regions (4a-4d) of the detection region (4), and to derive therefrom a position of the activation element in front of the at least one operator control element.

8. Operator control apparatus (1) according to one of the preceding claims, **characterized in that** the approach detection unit is designed to derive a movement of the activation element on the basis of the positions of the activation element which are sensed in chronological succession.

9. Operator control apparatus (1) according to one of the preceding claims, **characterized in that** the optical device comprises a cylinder lens (23) for focusing the detection radiation into a spatial plane.

10. Operator control apparatus (1) according to one of the preceding claims, **characterized in that** the optical device comprises a deflection prism (24a-24d) in order to cause the detection radiation (35) to fan out in an angle range in a spatial plane.

11. Operator control apparatus (1) according to one of the preceding claims, **characterized in that** the control unit is designed not to change the representation after the approach of the activation element to the at least one operator control element has been detected until a predefined time period has passed, wherein the predefined time period corresponds to a time which, in the case of an average movement of the activation element to at least one further operator control element (11), is detected between the detection of the approach of the activation element to the at least one operator control element on the basis of the received reflected and/or scattered detection radiation emitted into the detection region (4) and the detection of the approach to the at least one further operator control element (11) on the basis of the scattered and/or reflected detection radiation emitted into the at least one further detection region (42), wherein activation of the at least one further operator control element is generally not possible without penetration of the activation element into the detection region in front of the at least one operator control element.

12. Method for operating an operator control apparatus (1), wherein the operator control apparatus (1) comprises at least one operator control element for capturing user inputs and an approach detection device which senses an approach of an activation element, in particular of a body part of a user, to the operator control element before the operator control element is touched,
wherein electromagnetic detection radiation is emitted into a spatially limited detection region (4) in front of the operator control element by means of at least one lighting means (22a-22d), wherein the detection region (4) does not comprise an entire volume in front of the at least one operator control element, and by means of a receiver element (28) a portion of the detection radiation which is scattered at the activation element and/or reflected by this activation element is received when the activation element of the user approaches the at least one operator control element, and the approach is detected on the basis of the intensity of the received portion of the detection radiation, **characterized in that** the detection radiation (35) of the at least one lighting means (22a-22d) is emitted into a fan-shaped spatial region by means of an optical device.

13. Method according to Claim 12, **characterized in that** the at least one operator control element is a touchscreen (2), and when an approach is detected the representation on the touchscreen (2) is adapted and the detection radiation (35) of the at least one lighting means (22a-22d) is emitted into a detection region (4) lying in a detection plane, adjacent to an edge (5) of a display surface (3) of the touchscreen (2), wherein the detection plane and a plane of the display surface (3) enclose an angle ($\alpha$) of less than 90°.

14. Method according to either of Claims 12 and 13, **characterized in that** detection radiation is emitted by means of at least one further lighting means into a further detection region (41, 42) which is not located in front of the at least one operator control element, wherein the detection radiation emitted into the further detection region (41, 42) is modulated differently from the detection radiation emitted into the detection region (4), and the received scattered detection radiation is analyzed in terms of the modulation in order to determine separately the portion of the detection radiation (35) emitted and reflected/scattered into the detection region (4) and the portion of the detection radiation emitted and reflected/scattered into the further detection region (41, 42), and penetration of the activation element into the at least one further detection region (41, 42) is detected on the basis of the intensity of the portion of received reflected/scattered further detection radiation.

15. Method according to one of Claims 12 to 14, **characterized in that**, in addition to the detection radiation, additional detection radiation of additional lighting means (22a-22d) is emitted into the detection region (4), wherein the at least one lighting means (22a-22d) and the additional lighting means (22a-22d) emit the detection radiation into subregions (4a-4d) of the detection region (4) which are respectively different from one another, and the detection radiation and the additional detection radiation are modulated on a lighting-means-specific basis, and the received scattered and/or reflected detection radiation is evaluated in terms of the modulation in order to determine the scattered and/or reflected portions on a lighting-means-specific basis, and a position of the activation element is derived therefrom.

**Revendications**

1. Dispositif de commande (1) comprenant au moins un élément de commande pour capter des saisies d'utilisateur et un dispositif de reconnaissance d'approche qui est configuré pour capter une approche d'un élément d'actionnement, notamment une partie du corps, d'un utilisateur vers l'élément de commande avant une entrée en contact avec l'au moins un élément de commande,
le dispositif de reconnaissance d'approche comprenant une barrière photoélectrique à réflexion qui présente au moins un moyen lumineux (22a-22d) pour émettre un rayonnement électromagnétique de détection (35) devant l'au moins un élément de commande dans une zone de détection (4) délimitée dans l'espace, laquelle n'englobe pas un volume entier devant l'au moins un élément de commande, et un élément de réception (28) pour détecter une portion du rayonnement de détection (35) diffusée et/ou réfléchie sur l'élément d'actionnement de l'utilisateur lors d'une approche vers l'au moins un élément de commande, le dispositif de reconnaissance d'approche étant configuré pour reconnaître une approche au moyen d'une intensité du rayonnement de détection reçu,
**caractérisé en ce que**
l'au moins un moyen lumineux (22a-22d) est couplé avec une optique qui dévie l'émission du rayonnement de détection dans une zone d'espace en forme d'éventail.

2. Dispositif de commande (1) selon la revendication 1, **caractérisé en ce que** l'au moins un élément de commande est un écran tactile (2) qui est combiné avec un dispositif de contrôle qui, lors d'une approche reconnue de l'élément d'actionnement, modifie une représentation graphique sur une surface d'affichage (3) de l'écran tactile (2).

3. Dispositif de commande (1) selon la revendication 2, **caractérisé en ce qu'**au moins un élément de commande supplémentaire (7) est prévu pour capter les saisies d'utilisateur, lequel est disposé à côté d'un bord (5) de la surface d'affichage (3) de l'écran tactile (2), le rayonnement de détection de l'au moins un moyen lumineux (22a-22d) étant émis entre le bord (5) de l'écran tactile (2) et l'au moins un élément de commande supplémentaire (7) dans la zone de détection (4) qui se trouve dans un plan de détection, le plan de détection et un plan de la surface d'affichage (3) formant un angle ($\alpha$) inférieur à 90°, de sorte qu'un actionnement de l'au moins un élément de commande supplémentaire (7) soit possible sans pénétrer dans la zone de détection (4) avec l'élément d'actionnement.

4. Dispositif de commande (1) selon l'une des revendications précédentes, **caractérisé en ce que** le dispositif de reconnaissance d'approche comprend un ou plusieurs moyens lumineux (22a-22d) supplémentaires qui sont configurés pour émettre un rayonnement de détection dans la zone de détection (4), l'au moins un moyen lumineux (22a-22d) ainsi que le ou les moyens lumineux (22a-22d) supplémentaires émettant leur rayonnement de détection respectivement dans des zones spatiales (4a-4d) différentes de la zone de détection.

5. Dispositif de commande (1) selon la revendication 4, **caractérisé en ce que** le dispositif de reconnaissance d'approche comprend au moins un moyen lumineux supplémentaire pour émettre un rayonnement électromagnétique de détection dans une zone de détection supplémentaire (41, 42), différente de la zone de détection (4), au moins un dispositif de modulation pour moduler le rayonnement de détection émis par l'au moins un moyen lumineux de sorte qu'au moins le rayonnement de détection supplémentaire émis dans l'au moins une zone de détection supplémentaire (41, 42) se différencie du rayonnement de détection émis dans la zone de détection (4) au niveau de sa modulation, et une unité d'analyse qui est configurée pour analyser le rayonnement de détection réfléchi et/ou diffusé reçu du point de vue de sa modulation afin de déterminer au moins une portion diffusée/réfléchie du rayonnement de détection supplémentaire émis dans la zone de détection supplémentaire (41, 42) séparément de la portion diffusée et/ou réfléchie du rayonnement de détection émis dans la zone de détection (4) et pour reconnaître une pénétration de l'élément d'actionnement dans l'au moins une zone de détection supplémentaire (41, 42) au moyen de l'intensité de la portion réfléchie et/ou diffusée reçue du rayonnement de détection émis dans cette au moins une zone de détection supplémentaire (41, 42).

6. Dispositif de commande (1) selon l'une des revendications précédentes, **caractérisé en ce que** l'unité de contrôle est configurée pour omettre la modification de la représentation si, en plus de l'approche vers l'au moins un élément de commande, une pénétration de l'élément d'actionnement dans l'au moins une zone de détection supplémentaire (41, 42) est reconnue.

7. Dispositif de commande (1) selon l'une des revendications 5 ou 6, **caractérisé en ce que** le dispositif de modulation est configuré pour moduler individuellement pour chaque moyen lumineux le rayonnement de détection (35) émis dans la zone de détection par l'au moins un moyen lumineux (22a-22d) ou par le ou les moyens lumineux (22a-22d) supplémentaires et l'unité d'analyse est configurée pour analyser individuellement pour chaque moyen lumineux le rayonnement de détection diffusé et/ou réfléchi reçu du point de vue de la modulation afin de déterminer séparément les portions réfléchies/diffusées dans les différentes zones spatiales (4a-4d) de la zone de détection (4) et en dériver une position de l'élément d'actionnement devant l'au moins un élément de commande.

8. Dispositif de commande (1) selon l'une des revendications précédentes, **caractérisé en ce que** l'unité de reconnaissance d'approche est configurée pour dériver un mouvement de l'élément d'actionnement à l'aide des positions détectées chronologiquement de l'élément d'actionnement.

9. Dispositif de commande (1) selon l'une des revendications précédentes, **caractérisé en ce que** l'optique comprend une lentille cylindrique (23) pour concentrer le rayonnement de détection dans un plan de l'espace.

10. Dispositif de commande (1) selon l'une des revendications précédentes, **caractérisé en ce que** l'optique comprend un prisme de déviation (24a-24d) pour provoquer un déploiement en éventail du rayonnement de détection (35) dans une zone angulaire dans un plan de l'espace.

11. Dispositif de commande (1) selon l'une des revendications précédentes, **caractérisé en ce que** l'unité de contrôle est configurée pour effectuer la modification de la représentation après une reconnaissance de l'approche de l'élément d'actionnement vers l'au moins un élément de commande seulement après l'écoulement d'un intervalle de temps prédéfini, l'intervalle de temps prédéfini correspondant à une durée qui, lors d'un mouvement moyen de l'élément d'actionnement vers au moins un élément de commande supplémentaire (11), est identifiée entre la reconnaissance de l'approche de l'élément d'actionnement vers l'au moins un élément de commande à l'aide du rayonnement de détection émis, reçu réfléchi et/ou diffusé, dans la zone de détection (4), et la reconnaissance de l'approche vers l'au moins un élément de commande supplémentaire (11) à l'aide du rayonnement de détection émis, reçu réfléchi et/ou diffusé dans l'au moins une zone de détection supplémentaire (42), un actionnement de l'au moins un élément de commande supplémentaire n'étant généralement pas possible dans une pénétration de l'élément d'actionnement dans la zone de détection devant l'au moins un élément de commande.

12. Procédé pour faire fonctionner un dispositif de commande (1), le dispositif de commande (1) comprenant au moins un élément de commande pour capter des saisies d'utilisateur et un dispositif de reconnaissance d'approche qui capte une approche d'un élément d'actionnement, notamment une partie du corps, d'un utilisateur vers l'élément de commande avant une entrée en contact avec l'au moins un élément de commande,

un rayonnement électromagnétique de détection étant émis au moyen d'au moins un moyen lumineux (22a-22d) dans une zone de détection (4) délimitée dans l'espace devant l'au moins un élément de commande, la zone de détection (4) n'englobant pas un volume entier devant l'au moins un élément de commande, et une portion du rayonnement de détection diffusée sur l'élément d'actionnement et/ou réfléchie par cet élément d'actionnement étant reçue au moyen d'un élément de réception (28) lors d'une approche de l'élément d'actionnement de l'utilisateur vers l'au moins un élément de commande et l'approche étant reconnue au moyen d'une intensité de la portion du rayonnement de détection reçue,

**caractérisé en ce que**

le rayonnement de détection (35) de l'au moins un moyen lumineux (22a-22d) est émis dans une zone d'espace en forme d'éventail au moyen d'une optique.

**13.** Procédé selon la revendication 12, **caractérisé en ce que** l'au moins un élément de commande est un écran tactile (2) et, lors d'une approche reconnue, une adaptation de la représentation graphique sur l'écran tactile (2) est effectuée et le rayonnement de détection (35) de l'au moins un moyen lumineux (22a-22d) est émis à côté d'un bord (5) d'une surface d'affichage (3) de l'écran tactile (2) dans une zone de détection (4) qui se trouve dans un plan de détection, le plan de détection et un plan de la surface d'affichage (3) formant un angle ($\alpha$) inférieur à 90°.

**14.** Procédé selon l'une des revendications 12 ou 13, **caractérisé en ce qu'**un rayonnement de détection est émis au moyen d'au moins un moyen lumineux supplémentaire dans une zone de détection supplémentaire (41, 42), laquelle ne se trouve pas devant l'au moins un élément de commande, le rayonnement de détection émis dans l'au moins une zone de détection supplémentaire (41, 42) étant modulé différemment du rayonnement de détection émis dans la zone de détection (4), et le rayonnement de détection réfléchi et/ou diffusé reçu est analysé du point de vue de sa modulation afin de déterminer séparément la portion du rayonnement de détection (35) émis et diffusé/réfléchi dans la zone de détection (4) et la portion du rayonnement de détection supplémentaire émis et diffusé/réfléchi dans la zone de détection supplémentaire (41, 42), et la pénétration de l'élément d'actionnement dans l'au moins une zone de détection supplémentaire (41, 42) est reconnue au moyen de l'intensité de la portion réfléchie/diffusée reçue du rayonnement de détection supplémentaire.

**15.** Procédé selon l'une des revendications 12 ou 13, **caractérisé en ce qu'**un rayonnement de détection supplémentaire de moyens lumineux (22a-22d) supplémentaires est émis dans la zone de détection (4) en plus du rayonnement de détection, l'au moins un moyen lumineux (22a-22d) et les moyens lumineux (22a-22d) supplémentaires émettant le rayonnement de détection respectivement dans des zones spatiales (4a-4d) différentes les unes des autres de la zone de détection (4) et le rayonnement de détection ainsi que le rayonnement de détection supplémentaire sont modulés individuellement pour chaque moyen lumineux et le rayonnement de détection diffusé et/ou réfléchi reçu est interprété du point de vue des modulations afin de déterminer individuellement pour chaque moyen lumineux les portions diffusées et/ou réfléchies et une position de l'élément d'actionnement en est dérivée.

FIG. 1

FIG. 2

**FIG. 3**

**FIG. 4**

**FIG. 5**

FIG. 6

FIG. 7

FIG. 8

FIG. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006037156
- WO 2004078536 A
- DE 102004033275 A1
- EP 1932725 A1
- US 20040140959 A1
- US 20080053233 A
- JP 2000329577 A